# EUROPÄISCHE PATENTANMELDUNG

(11) **EP 0 745 654 A1**
(43) Veröffentlichungstag der Anmeldung: **04.12.1996**
(21) Anmeldenummer: 96107711.2
(22) Anmeldetag: 15.05.1996
(51) Int. Cl.: C09J 7/02, C09J 4/06, C09J 133/04

(54) **Dicing Tape**

(30) Priorität: 02.06.1995 DE 19520238
(71) Anmelder: Beiersdorf Aktiengesellschaft, D-20245 Hamburg (DE)
(72) Erfinder: Gleichenhagen, Peter, Dr., 22417 Hamburg (DE); Pfaff, Ronald, Dr., 20253 Hamburg (DE); Müller, Anja, 22459 Hamburg (DE); Westphal, Andreas, 22049 Hamburg (DE)

(57) **Zusammenfassung**

Dicing Tape zurvorrübergehenden Fixirung von Wafern und dergleichen mit einem Folienträger, der UV-durchlässig ist, dadurch gekennzeichnet, daß auf einer Seite des Folien-Trägers eine Haftklebemasse angeordnet ist, deren Klebkraft mittels UV-Strahlung abgesenkt werden kann, und die enthält:
a) 30 - 90 Gewichtsteile eines zähelastischen Basispolymers auf (Meth)acrylatbasis, das Gruppierungen enthält, die unter Anregung durch UV-Strahlung Polymerisationen auslösende Radikale bilden,
b) 10 - 70 Gewichtsteile mindestens einer niedermolekularen Verbindung, die mindestens zwei polymerisierbare Doppelbindungen von (Meth)acryltyp enthält,
c) ggf. 5 - 60 Gew.-Teile klebrigmachende Harze.

## Beschreibung

Die Erfindung betrifft eine haftklebend ausgerüstete Folie zur vorübergehenden Fixierung von Silizium-Scheiben - sogenannten Wafern - während des Schneidprozesses bei der Chip-Herstellung. Für derartige Haftklebe-Artikel ist die Bezeichnung Dicing-Tape gebräuchlich.

Für die Durchführung des Schneidprozesses wird das Dicing-Tape mit dem auf ihm haftenden Wafer in einen Tragrahmen geklebt oder anderweitig darin befestigt. Anschließend wird der Wafer mit einer Diamant-Kreissäge in einzelne Chips zersägt. Danach werden die Chips mittels mechanischer Vorrichtungen von dem Dicing-Tape abgenommen.

Damit fehlerfreie Chipkanten erzeugt werden können, und um die Ausschußquote möglichst gering zu halten, muß die Fixierung des Wafers den Kräften beim Sägen ohne Verschiebung standhalten. Beim anschließenden Vereinzeln der Chips muß die Klebkraft des Tapes hingegen so gering sein, daß alle Chips frei von Verunreinigungen und ohne gegenseitige Berührung von ihm abgehoben werden können. Die hierzu notwendige Absenkung der Klebkraft nach dem Sägen wird mittels Vernetzung der Haftklebemasse mit entsprechender Versprödung bewirkt. Die Vernetzung wird durch UV-Strahlung erzeugt.

Für diesen Anwendungszweck werden Haftklebemassen verwendet, die aus einem mehr oder weniger haftklebenden Basispolymer aus Poly(meth)acrylaten bestehen, dem Oligomere und/oder Monomere mit polymerisierbaren Doppelbindungen und UV-strahlungsaktive Photoinitiatoren zugemischt werden.

Im EP 0 194 706 wird ein haftklebendes Compound beschrieben, das aus einem elastischen mit Polyisocyanaten vernetzten Poly(meth)acrylat besteht, dem mehrfach ungesättigte Acrylat-Monomere bzw.-Oligomere, Photoinitiatoren sowie harzartige Klebrigmacher und/oder Silicagel zugemischt werden.

Das EP 0 298 448 nennt über Polyisocyanate vernetzte Polyacrylhaftkleber, die mit mehrfach acrylierten Cyanuraten oder Isocyanuraten und Photoinitiatoren gemischt werden.

Das EP 0 622 833 beansprucht eine Haftklebemasse, die aus einem OH-Gruppen enthaltenden und mit Diisocyanaten vernetzten Polyacrylat, einem Urethanoligomer vom MG ca 6000 mit mindestens zwei Acryldoppelbindungen und Photoinitiatoren hergestellt wird.

Eine ähnlich hergestellte Haftklebemasse wird in der DE 3 639 266 beschrieben. Im JP 0 60 49 420 wird eine Haftklebemasse beansprucht, die aus einem Basispolymer, polyfunktionellen Urethanen mit MG 15 000-50 000, Weichmachern und Photoinitiatoren gemischt wird.

Abweichend von dem oben allgemein beschriebenen Verfahren nennt die EP 0 588 180 eine nicht compoundierte Haftklebemasse, die einen Photoinitiator einpolymerisiert enthält und bei UV-Bestrahlung an Klebkraft verliert. Ein Hauptbestandteil dieses Acrylcopolymers sind u.a. Acrylatester-Einheiten mit Alkylgruppen ≦ C₁₄.

Mit zunehmender Perfektionierung, Automatisierung und entsprechender Beschleunigung der Taktzeiten, wechselnder Fertigungsabläufe sowie der erwünschten Verringerung von Ausschuß sind die Leistungsanforderungen an ein Dicing-Tape gestiegen, sodaß mit dem heutigen Stand der Technik nicht alle Parameter zufriedenstellend erfüllt werden.

So werden heute Reinheitsgrade nach dem Ablösen vom Dicing-Tape gefordert, bei denen neben einer optisch-mikroskopisch einwandfreien Oberfläche auch keinerlei unsichtbareVeränderung, wie sie sich z.B.in der Änderung der Oberflächenspannung äußern kann, geduldet wird.

Außerdem muß die absolute Reinheit und einwandfreie Funktionstüchtigkeit des Dicing-Tapes heute für sehr unterschiedliche Oberflächenrauhigkeiten und Oberflächenvergütungen verschiedener Wafer-Typen gewährleistet sein. Auch Randbedingungen, wie die verschiedene klebtechnische Beanspruchung bei wechselnden Chipgrößen oder langzeitigem Verweilen des Wafers auf dem Tape vor oder der Chips nach dem Schneidprozeß, wobei eine sichere Haftung ohne Anstieg der Klebkraft verlangt wird, müssen erfüllt werden.

Aufgabe der Erfindung war es, hier Abhilfe zu schaffen, insbesondere ein Dicing Tape zu schaffen, das die Nachteile des Standes der Technik nicht oder nicht in dem Maße aufweist.

Die Haftklebemasse des erfindungsgemäßen Dicing-Tapes setzt sich aus folgenden Komponenten zusammen:
1. 30-90 Gew.Teile eines zähelastischen Basispolymers auf (Meth)acrylatbasis, dessen Polymerkettenmoleküle insbesondere aus (Meth)acryl-Estereinheiten mit Esterresten von C₁ - C₁₂ aufgebaut sind und zusätzlich polare Funktionen wie z.B.Amid-, Amino-, Hydroxy-, Carboxy-, Keto- und Ethergruppen enthalten können und in dem insbesondere statistisch verteilt Gruppierungen vorhanden sind, die unter Anregung durch UV-Strahlung Polymerisationen auslösende Radikale bilden. Außerdem können zur Verbesserung der Verträglichkeit mit den unter 2 genannten Verbindungen Comonomere wie z.B. Styrol in kleineren Anteilen enthalten sein.
2. 10-70 Gew.Teile einer oder mehrerer niedermolekularer Verbindungen, die mindestens zwei, vorzugsweise mehrere polymerisierbare Doppelbindungen vom (Meth)acryltyp enthalten, vorzugsweise mit dem Basispolymer verträglich sind und insbesondere Molekulargewichte um 200 bis 15000 , vorzugsweise 250 bis 5000 haben.
3. Neben den unter 1.und 2. genannten notwendigen Bestandteilen können zur Regulierung der Klebkraftstärke 5-60 Gew.Teile klebrigmachende Harze enthalten sein. Außerdem kann in den Compounds mittels vorhandener reaktionsfähiger Gruppen mit geringen Zusätzen von Vernetzern ein zur UV-Strahlungs-Vernetzung zusätzliches Netzwerk aufgebaut sein.

Die Molekulargewichte der unter 1. beschriebenen Polymere können im Bereich 80 000 bis 800 000 liegen. Die Polymeren werden vorzugsweise in Lösung nach technisch bekannten Verfahren radikalisch polymerisiert.

Die im Basispolymer vorhandenen unter UV-Strahlung Radikale bildenden Gruppen enthalten insbesondere Funktionen, die entsprechend bekannten UV-Photoinitiatoren aufgebaut sind. Vorzugsweise werden diese photoaktiven Zentren durch radikalische Copolymerisation in die Polymeren eingebaut. Die hierzu notwendigen Photoinitiatoren enthalten in diesem Falle eine radikalisch polymerisierbare Doppelbindung. Als Beispiele seien genannt das Benzoin-acrylat, das ionische, wasserlösliche (2-Acryloyloxyethyl)(4-benzoylbenzyl)- dimethyl- ammoniumbromid und das 4-(2-Acryloyloxyethoxy)-phenyl-(2-hydroxy-2-propyl)-keton. Bereits 1 Gew.% dieser Verbindungen im Basispolymer können für die Durchhärtung des gesamten Compounds ausreichen. Bei geringer UV-Dosis sind aber auch größere Mengen um ca 5-10Gew.% möglich. Zusätzlich können auch insbesondere radikalisch polymerisierbare Photoinitiatoren mit einer oder mehr polymerisationsfähigen Doppelbindungen je Molekül oder auch nicht polymerisierbare Photoinitiatoren in den Compounds mitverwendet werden.

Vorteilhaft können dabei Photoinitiatoren mit unterschiedlichen Absorptionsmaxima eingesetzt werden. Dadurch kann die Funktionsfähigkeit des Dicing-Tapes auch bei Verwendung unterschiedlicher UV-Strahlungsquellen mit stärker differierenden Strahlungsspektren gewährleistet werden, sonfern einer der eingesetzten Photoinitiatoren mit seinem Absorptionsmaximum annährend beim Maximum des Strahlungsspektrums oder zumindest im Wellenlängen-Bereich der jeweiligen UV-Strahlungsquelle in ausreichender Konzentration vorliegt.

Von den unter 2. genannten Verbindungen werden jene mit Acryldoppelbindungen bevorzugt eingesetzt, insbesondere solche, die rasch und unter deutlichem Schrumpf zu sprödem Material durchhärtbar sind.Als Beispiele seien Trimethylolpropan-Triacrylat und Dipentaerythritol- Hexaacrylat genannt.

Als Beispiele für die unter 3. erwähnten Zusätze von Vernetzern seien Al-Acetylacetonat oder Diisocynate und Diepoxyde, die über Carboxygruppen bzw. Hydroxygruppen des Basispolymers ein Netzwerk aufbauen, genannt. Falls notwendig, lassen sich mit Zusätzen von 0,1 bis 5% die Compounds soweit verfestigen, daß ausreichende Haftklebeeigenschaften resultieren.

Als Trägerfolien für die beschriebenen Haftklebecompounds eignen sich Materialien, die eine hohe UV-Strahlungs-Durchlässigkeit besitzen und als Folien eine ausreichende Elastizität und Festigkeit aufweisen. Als Beispiele zu nennen sind Polyethylen, Polypropylen, PVC, Ethylen/Vinylacetat-Copolymere und Ethylen/Acrylat-Copolymere. Die Verankerung der Haftklebemasse kann, falls notwendig, durch eine Corona-Vorbehandlung oder mittels einer geeigneten (UV-durchlässig) Primerschicht erhöht werden. Die Klebemassen-Oberfläche kann durch eine dehäsiv ausgerüstete Abdeckfolie bis zum Anwendungszeitpunkt vor Verschmutzung geschützt werden. Bei Rollenware kann in rationellerer Weise die rückseitig mit UV-durchlässigen Dehäsiv-Mitteln ausgerüstete Trägerfolie diese Aufgabe übernehmen. Die Dicken der Folien können zwischen 20µm und 400 µm vorzugsweise 60µm und 150µm liegen. Die Beschichtungsstärken der Haftklebemassen liegen im Bereich 7g/m² bis 30g/m² vorzugsweise 10g/m² bis 20g/m².

Mit den beschriebenen Haftklebemassen bzw. Dicing Tape werden mehrere Vorteile erreicht:

Die nach dem Sägeprozeß notwendige UV-strahlungsinitiierte Vernetzung wird definiert an den Molekülketten des Basispolymers ausgelöst und rasch über die reaktionsfähigen Doppelbindungen der zugemischten Monomeren bzw. Oligomeren fortgeführt, sodaß sehr schnell ein phaseneinheitliches festes, sprödes Polymer entsteht. Der Wirkungsgrad der an die Basispolymerketten gebundenen Photoinitiatoren ist höher als bei lediglich zugemischten Photoinitiatoren. Außerdem wird eine ungleichmäßige Verteilung oder gar Konzentrationsverringerung des Photoinitiators, die bei der Lagerung der Tapes durch Diffusion oder bei der Herstellung durch den Trocknungsprozeß verursacht werden kann, unterbunden.

Neben der raschen Verfestigung wird durch den deutlichen Schrumpf der Compounds, der bei der UV-induzierten Vernetzung im Compound entsteht, die rückstandfreie leichte Ablösung von den mehr oder weniger rauhen Waferoberflächen gewährleistet. Bei einer nur zwischen bereits bestehenden Polymerketten ausgelösten Vernetzung, wie sie in der EP 0 588 180 beschrieben wird, sind diese wünschenswerten Veränderungen geringer ausgeprägt.

Wegen des hohen Wirkungsgrads bei der Klebkraft-Absenkung kann das Dicing Tape auch mit UV-Kaltlichtstrahlern ausreichend rasch gehärtet werden. Diese Strahler haben zwar eine deutlich geringere Leistung als die zur Zeit üblicherweise eingesetzten Hg-Hochdruck-strahler und strahlen auch keine die Vernetzungsreaktion fördernde Wärme ab, erzeugen aber eine nahezu monochromatische Strahlung. Mit einer gezielten Abstimmung des Absorptionsspektrums vom Photoinitiator auf eine derartige Strahlungsquelle kann die Vernetzung in einem ausgewählten engen Frequenzbereich durchgeführt werden, der keine Ozonbildung verursacht. Bei den leistungsstarken Hg-Hochdruckstrahlern wird hingegen ein breitgefächertes UV-Spektrum erzeugt, das weit in den hochfrequenten, Ozon synthetisierenden Bereich reicht.

Nachfolgend wird die Erfindung an Hand von Beispielen näher beschrieben, ohne sie dadurch unnötig beschränken zu wollen.

### Beispiel 1

In einer 2 L-4Hals-Stahl-Apparatur, ausgerüstet mit Rückflußkühler, Kühler, Rührer, Thermometer, Dosiervorrichtung und Stickstoff-Einleitrohr, werden 252g Acrylsäure-n-butylester (56Gew.%bez.auf Monomere), 180g Acrylsäuremethylester (40Gew.%bez. auf Monomere), 9g Acrylsäure (2Gew.%bez. auf Monomere), 9g Benzoinacrylat (2Gew.%bez. auf Monomere) und 300g Aceton mittels radikalischer Initiierung durch 0,5g Vazo 67 (Du Pont) unter sauerstoffreien Bedingungen bei 64°C-56°C polymerisiert. Zur Regulierung der Viskosität und des Molekulargewichts bzw. zur Fortführung der Polymerisation werden während der Reaktion weitere 525g Aceton, 75g Isopropanol, 1,5g Vazo 67 (Fa Du Pont) sowie 0,5g Perkadox 16 (Fa Akzo Nobel) portionsweise zudosiert. Nach 12 Stunden Reaktionszeit wird eine Polymerlösung mit 33% Feststoff erhalten. Das Polymer hat eine rel. Viskosität von 3,46 bei 25⁰C in Toluol.

59 g des Polymers werden in Lösung mit 0,40g Aluminium-acetylacetonat gemischt. Zu dieser Lösung werden 40g eines mehrfach acrylierten Oligomergemisches aus 70% hexa-acryliertem aromatischen Urethans und 30% eines Pentaerythritoltri/tetra-acrylats (Ebecryl 220 UCB Chemicals) gegeben und zu einer homogenen Lösung verrührt. Diese Lösung wird auf eine corona-vorbehandelte Seite einer 60µm dicken Folie aus einem Copolymer von 85% Ethylen und 15% Acrylsäuren-butylester geschichtet und 5min. bei 120°C getrocknet, sodaß ein Prüfmuster für ein Dicing Tape entsteht. Die Haftklebeschicht hat eine Dicke von 13µm.

### Klebkraftmessung:

Die rauhe Seite eines Wafers (150mm ⌀) wird mit einem 20mm breiten aus dem Prüfmuster geschnittenen Klebebandstreifen luftblasenfrei überklebt. Dabei wird der Prüfstreifen mit einer 2kg schweren Walze angedrückt. Nach einer Kontaktzeit von 30 min wird der Prüfstreifen in einer Zugprüfmaschine im Winkel von 90⁰ mit 300mm/min abgezogen.

### Klebkraftwerte:

- 1,66 N/cm: vor der UV-Bestrahlung
- 0,28 N/cm: nach der UV-Bestrahlung mit UV-Kaltlichtstrahler 0,5W/cm, 254nm, 50sec ca. 2cm Abstand
- 0,15 N/cm: nach der UV-Bestrahlung mit Hg-Hochdruckstrahler 80W/cm, 3sec ca 15cm Abstand

### Beispiel 2

Entsprechend Beispiel 1 wird ein Polymer aus 59Gew.% Acrylsäure-n-butylester, 35Gew% Acrylsäure-methylester, 3Gew.% Acrylsäure und 3Gew.% Benzoinacrylat hergestellt.

Die rel. Viskosität des Polymers beträgt 3,013 bei 25°C gelöst in Toluol.

50g des Polymers werden mit 30g des oben beschriebenen Urethanacrylats (Ebecryl 220) und 20g Trimethylolpropan-triacrylat sowie 0,1g Aluminiumacetylacetonat wie im Beispiel 1 beschrieben gemischt und zu einem Prüfmuster verarbeitet. Die Haftklebeschicht hat eine Dicke von 10µm.

### Klebkraftwerte:

- 1,26 N/cm: vor der UV-Bestrahlung
- 0,20 N/cm: UV-Kaltlichtstrahler 0,5W/cm, 254nm, 50sec, ca 2cm Abstand
- 0,14 N/cm: Hg-Hochdruckstrahler 80W/cm, 3sec, ca 15cm Abstand

### Beispiel 3

Entsprechend Beispiel 2 wird ein Polymer hergestellt,das anstelle von Benzoinacrylat als Photoinitiator 3Gew.% 4-benzoyl-N,N-dimethyl-(2-(1-oxo-2-propenyloxy)ethyl)benzene-methanamonium bromid (Quantacure Fa Rahn AG) einpolymerisiert enthält.Die rel. Visk. des Polymers beträgt 4,317 bei 25°C gelöst in Toluol.

60g des Polymers werden mit 40g des Urethanacrylats (Ebecryl 220) und 0,5g Aluminium-acetylacetonat wie oben beschrieben gemischt und zu einem Prüfmuster verarbeitet. Die Haftklebeschicht hat eine Dicke von 9µm.

### Klebkraftwerte:

- 1,10 N/cm: vor der UV-Bestrahlung
- 0,20 N/cm: UV-Kaltlichtstrahler 0,5W/cm, 254nm, 50sec, ca 2cm Abstand.
- 0,20 N/cm: Hg-Hochdruckstrahler 80W/cm, 2 sec, ca 15cm Abstand

## Patentansprüche

1. Dicing Tape zur vorrübergehenden Fixirung von Wafern und dergleichen mit einem Folienträger, der UV-durchlässig ist, dadurch gekennzeichnet, daß auf einer Seite des Folien-Trägers eine Haftklebemasse angeordnet ist, deren Klebkraft mittels UV-Strahlung abgesenkt werden kann, und die enthält:
a) 30 - 90 Gewichtsteile eines zähelastischen Basispolymers auf (Meth)acrylatbasis, dessen Polymerkettenmoleküle Gruppierungen enthalten, die unter Anregung durch UV-Strahlung Polymerisationen auslösende Radikale bilden,
b) 10 - 70 Gewichtsteile mindestens einer niedermolekularen Verbindung, die mindestens zwei polymerisierbare Doppelbindungen von (Meth)acryltyp enthält,
c) ggf. 5 - 60 Gew.-Teile klebrigmachende Harze.

2. Dicing Tape nach Anspruch 1, dadurch gekennzeichnet, daß das Basispolymer aus Estereinheiten mit Esterresten von C₁-C₁₂ aufgebaut ist.

3. Dicing Tape nach Anspruch 1, dadurch gekennzeichnet, daß das Basispolymer zusätzlich polare Funktionen, wie Amid-, Amino-, Hydroxy-, Carboxy-, Keto- und/oder Ethergruppen enthält.

4. Dicing Tape nach Anspruch 1, dadurch gekennzeichnet, daß das Basispolymer zusätzlich zu b) Comonomere, wie Styrol, enthält.

5. Dicing Tape nach Anspruch 1, dadurch gekennzeichnet, daß die Verbindungen gemäß b) mit dem Basispolymer verträglich sind und Molekulargewichte von 200 - 15000, insbesondere 250 - 5000 haben.

6. Dicing Tape nach Anspruch 1, dadurch gekennzeichnet, daß zusätzlich Vernetzer vorhanden sind.

7. Dicing Tape nach Anspruch 1, dadurch gekennzeichnet, daß das Basispolymer Molekulargewichte von 80 000 bis 800 000 hat.

8. Dicing Tape nach Anspruch 1, dadurch gekennzeichnet, daß das Basispolymer Benzoinacrylat copolymerisiert enthält.

9. Dicing Tape nach Anspruch 1, dadurch gekennzeichnet, daß zusätzlich weitere Photoinitiatoren mitenthalten sind.

10. Verwendung eines Dicing Tapes nach einem der Ansprüche 1 - 9 zum vorübergehenden Fixieren von Wafern oder dergleichen, wobei die Klebkraft gegenüber einem darauf fixierten Wafter oder dergleichen mittels UV-Bestrahlung durch den Folien-Träger hindurch derart reduziert wird, daß dieser sauber und ohne Beschädigung von dem Dicing Tape abgenommen werden kann.
